# EUROPEAN PATENT SPECIFICATION

(11) **EP 4 121 783 B1**
(45) Date of publication and mention of the grant of the patent: **07.05.2025**
(21) Application number: 20715288.5
(22) Date of filing: 20.03.2020
(51) Int. Cl.: G01R 1/20

(54) **POWER ELECTRONICS CIRCUITRY HAVING HIGH-POWER BUSBAR WITH CONTROLLABLE RESISTANCE**
LEISTUNGSELEKTRONISCHE SCHALTUNG MIT HOCHLEISTUNGSSCHIENE MIT STEUERBAREM WIDERSTAND
CIRCUIT ÉLECTRONIQUE DE PUISSANCE COMPRENANT UNE BARRE DE PUISSANCE ÉLEVÉE À RÉSISTANCE CONTRÔLABLE

(43) Date of publication of application: 25.01.2023
(73) Proprietor: ABB SCHWEIZ AG, 5400 Baden (CH)
(72) Inventor: ASOODAR, Mohsen, 171 71 Solna (SE); MOHANAVEERAMANI, Aravind, 722 19 Västerås (SE); STAMATIOU, Georgios, 772 17 Västerås (SE)
(74) Representative: Kransell & Wennborg KB
(86) International application number: PCT/EP2020/057895
(87) International publication number: WO 2021/185463

(56) References cited:
- DE-A1- 102004 042 719
- US-A- 5 300 917
- US-A- 6 166 619
- US-A1- 2009 066 600
- US-A1- 2011 241 820

## Description

### TECHNICAL FIELD

The present disclosure relates to the field of continuous monitoring of electric components, such as power electronic components. In particular, the disclosure proposes a busbar with controllable resistance that allows convenient current measurements.

### BACKGROUND

To identify a failure of a power electronic device early, the currents flowing to and from the device may be monitored. It is oftentimes preferred in high-power applications to monitor the currents contactlessly, such as by providing connection lines of the device with a Rogowski coil or Hall-effect sensor, both of which utilize inductive phenomena. For examples, see [1] S. Mocevic et al., "Comparison between desaturation sensing and Rogowski coil current sensing for shortcircuit protection of 1.2 kV, 300 A SiC MOSFET module", proceedings of the 2018 IEEE Applied Power Electronics Conference and Exposition (APEC), San Antonio 2018, pages 2666-2672 and [2] S. J. Nibir et al., "Wideband contactless current sensing using hybrid magnetoresistor-Rogowski sensor in high frequency power electronic converters", ibid., pages 904-908.

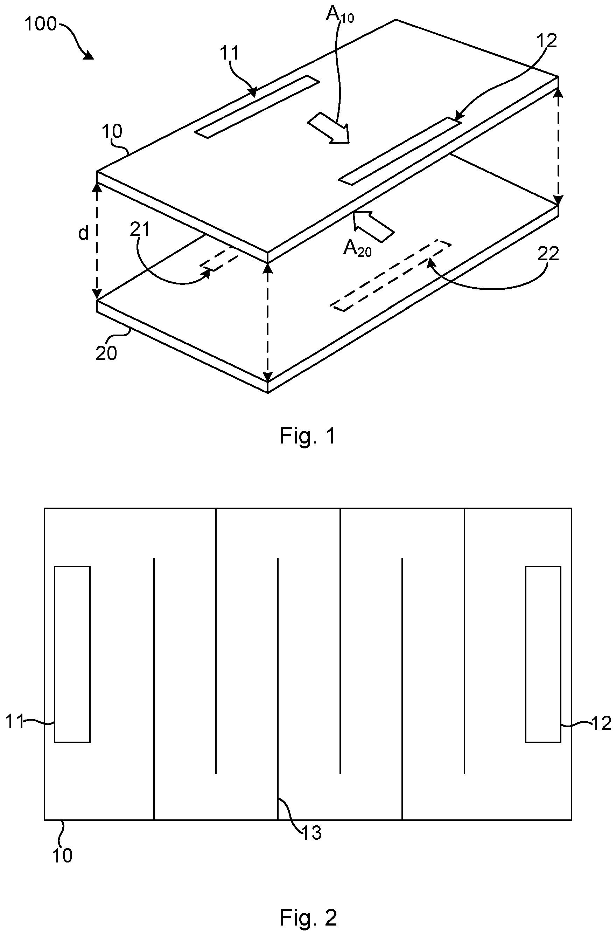

To connect power-electronic building blocks (PEBBs), a busbar 100 with the example structure shown in figure 1 may be used. The depicted busbar 100 is composed of two planar conductors or conductive layers, shown as parallel plates 10, 20 separated by a distance d of the order of hundreds of micrometers. For visibility, the distance d has been enlarged in figure 1. The external side of each plate comprises an input area 11, 21 and an output area 12, 22, within which it is suitable to connect a current source or current consumer, e.g., by welding, soldering, clamping means or mechanical connectors of the fixed or detachable type.

In one example use case, a source-side device (not shown) is connected at the input areas 11, 21 at the left-hand edge of the busbar and a load-side device (not shown) is connected at the output areas 12, 22 at the right-hand edge of the busbar. A first current A₁₀ flows through the upper plate 10, and a second current A₂₀ flows through the lower plate 20; the orientation of the hollow arrows representing these currents refer to a reference polarity of each current rather than suggesting that the current is unidirectional at all times.
Conventionally, a busbar is designed to have small resistance, so as to limit thermal losses, and very small inductance. A reduced inductance means that the inductive response to a sudden change in the circuit characteristics - as may result from an overvoltage, discharge, short-circuit or the like - is less pronounced, and will thereby protect the connected PEBBs. This is also valid for busbars designed to transfer direct current.
US5300917A discloses a junction box apparatus for a vehicle. The junction box apparatus comprises a shunt busbar and test points. The shunt busbar, which may be manu-factured by stamping an electrical conductor from flat copper or brass stock, comprises a body portion, two pairs of male terminals for coupling the shunt busbar in a current loop. A load and a power supply can be placed in the current loop. A comparator is connected to the terminals across the shunt busbar.
Shunt-based current monitoring is available for some low-power applications but has not been successfully upscaled to the high-power case. It would be desirable to generalize this robust and relatively simple monitoring technique to PEBB applications.

### SUMMARY

One objective is to make available shunt-based current monitoring for PEBB applications. It is a particular objective to propose a busbar allowing such current monitoring.

In the invention according to independent claim 1, there is provided a busbar comprising a first conductive layer with an input area and an output area, wherein the conductive layer has a machined pattern defining a meandering conductive path between the input area and output area.

Because the meandering conductive path is longer than a straight conductive path directly from the input to the output area, the machined pattern increases the resistance of the conductive path in a controlled fashion. The increase in resistance is achieved without increasing the outer dimensions of the busbar. For comparison, the conductive path from the input area 11 to the output area 12 of the upper plate 10 of the busbar 100 shown in figure 1 is straight and therefore less resistive than an imaginary meandering conductive path in the same plate 10. By providing the busbar with a desired resistance, it becomes possible to monitor the current flowing through the busbar by monitoring a voltage drop along the conductive path.

A further advantage of the invention is that the busbar can be manufactured in a simple fashion by manipulation of a conventional planar busbar for PEBBs. A still further advantage in comparison with the use of a Rogowski coil that no delicate measuring components, such as an integrator circuit, are needed for the measurement as such.

In the invention, power electronics circuitry is provided, which comprises: the busbar; a direct-current capacitor connected at the input area of the busbar; a semiconductor device connected at the output area of the busbar; and a current monitoring arrangement adapted to sense a voltage drop over said meandering conductive path.

Generally, all terms used in the claims are to be interpreted according to their ordinary meaning in the technical field, unless explicitly defined otherwise herein. The conductive path is one through which the current from the input area to the output area must pass; alternatively, the conductive path is one of several paths in a group which represents all possible paths from the input area to the output area. To render an input or output area suitable for its purpose of connecting a current source or current consumer, the necessary structural modification may be very limited or even non-existent; in fact, the identification of an input/output area in the sense of the claims may refer to an intended use. In the sense of the claims, moreover, the conductive path is meandering if it comprises at least one meandering section or portion. The machined pattern, if it penetrates all the way through the busbar layer, may alternatively be referred to as a slot pattern. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

Aspects and embodiments are now described, by way of example, with reference to the accompanying drawings, on which:
figure 1 is a perspective view of a busbar with two conductive layers according to the state of the art;
figure 2 is a top view of a conductive layer in a busbar with a machined pattern, according an embodiment of the present invention;
figure 3 is a top view of a conductive layer in a busbar according an embodiment of the present invention comprising a machined pattern defining four parallel conductive paths as well as connection sites allowing the sensing of a voltage drop over the conductive path;
figure 4 is a top view of a conductive layer in a busbar according an embodiment of the present invention comprising a machined pattern defining four parallel conductive paths as well as connection sites to which example measurement circuitry is connected; and
figures 5 to 7 are top views of a conductive layer in a busbar, occasionally with connection sites for voltage sensing, according to further embodiments of the present invention.

### DETAILED DESCRIPTION

The aspects of the present disclosure will now be described more fully with reference to the accompanying drawings, on which certain embodiments of the invention are shown. These aspects may, however, be embodied in many different forms and should not be construed as limiting; rather, the disclosed embodiments are provided by way of example so that this disclosure will be thorough and complete, and to fully convey the scope of all aspects of invention to those skilled in the art. Like numbers refer to like elements throughout the description.

Figure 1, which has been briefly discussed in a previous section of this disclosure, shows a two-layer busbar 100 according to the state of the art. Busbars according to the present invention, which differ from the state of the art mainly by the presence of the machined pattern, may have same or similar generic properties as the busbar shown in figure 1. In terms of possible further differences, busbars according to the present invention may include one, two or more conductive layers. The layers may be separated by a void (e.g., air, insulating gas, pressurized or at atmospheric pressure) or an insulating layer. Alternatively or additionally, the placement of the input and output areas 11, 21, 21, 22 may be different, such as on the edge side (i.e., laterally) or extending around the edge of the plate. The width-to-length ratio of the busbar may differ from that suggested in figure 1.

Figure 2 is a top view of a conductive layer 10 in a busbar with a machined pattern, according an embodiment of the present invention. The machined pattern 13 is composed of six slots (vertically oriented in figure 2) in a baffle-like arrangement. It may be said to define a meandering conductive path, in which five vertical segments can be discerned between nearby slots of the machined pattern 13. The conductive path is therefore noticeably longer than the distance from the input area 11 to the output area 12. In approximate terms, the machined pattern 13 in figure 2 defines a conductive path that is at least twice as long as said distance, which in itself may double the resistance compared to a conductive layer without any machined pattern. Additionally, the conductive path is narrower for the most part than the straight current path on a pattern-free conductive layer, which normally increases the resistance.

The machined pattern 13 may be a chemically or photochemically machined pattern, preferably an etched pattern, a laser-cut pattern or a waterjet-cut pattern. The machined pattern 13 may penetrate through the first conductive layer. In particular, it may be composed of cut-through slots. The width of the machined pattern 13 may be approximately 1 mm or less; in other embodiments, the width of the machined pattern 13 may be less than 3 mm or less than 2 mm.

Machined patterns which define a conductive path with parallel adjacent opposite sections may be advantageous since they avoid an uncontrolled inductance increase when the resistance is brought to increase by the addition of the machined pattern. For example, consecutive vertical segments of the conductive path according to figure 2 will convey oppositely directed currents. Preferably, the provision of the machined pattern increases the resistance between the input area 11 and the output area 12 by a factor greater than or equal to a concomitant inductance increase. Expressed in mathematical notation, if the resistance increases by a factor *k_{R}* and the inductance increases by a factor *k_{L}* when the machined pattern is added, then preferably *k_{R}* ≥ *k_{L}* applies. It is recalled that the factors *k_{R}*, *k_{L}* can be determined by theoretical calculation or simulation. Likewise, while it is clearly possible to manufacture a busbar according to the invention by starting from a pattern-free busbar layer and adding the machined pattern subsequently, the invention does not require this specific sequencing; rather, the pattern may be present from the earliest stages of the manufacturing process.

Other embodiments of the invention may be adapted for different use cases, with different requirements for the resistance increase. This requirement may be the result of a design tradeoff between the desire to limit thermal losses (tending to reduce the resistance) and reach an acceptable measurement accuracy (tending to increase the resistance). For example, the conductive path may be at least 110%, preferably at least 125%, preferably at least 150%, preferably 2 times, preferably 5 times or preferably 10 times as long as the distance from the input area 11 to the output area 12.

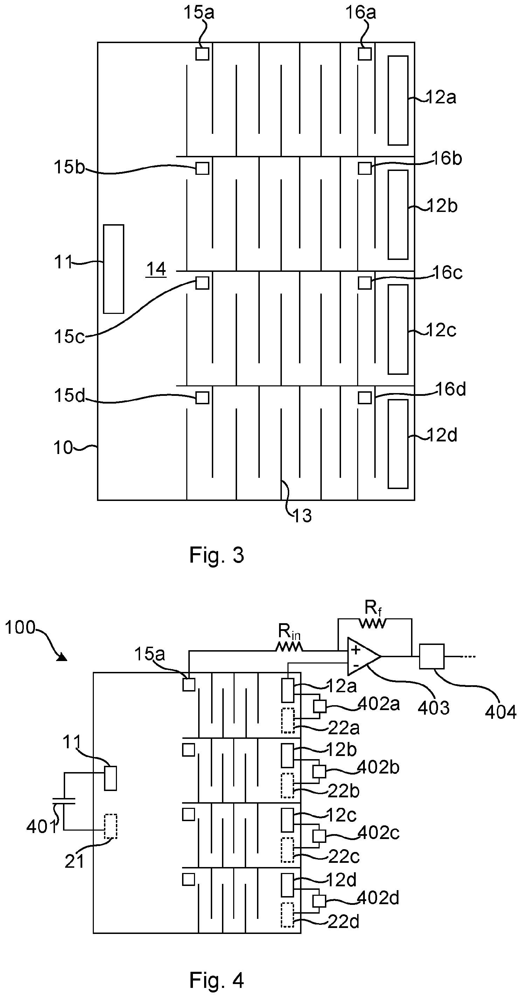

Figure 3 is a top view of a conductive layer 10 in a busbar according an embodiment of the present invention. The conductive layer 10 has a machined pattern 13 defining four parallel conductive paths as well as connection sites 15, 16 allowing the sensing of a voltage drop over the portion of the conductive path that extends between the connection sites 15, 16. From the input area 11, which is common to all four paths, each path passes through a common portion 14 followed by a respective meandering portion that ends in a respective one of the four output areas 12. For this purpose, the machined pattern 13 not only comprises slots (vertically oriented in figure 3) in baffle-like arrangements but also slots (horizontally oriented in figure 3) which delimit one meandering portion of a conductive path from an adjacent one. The common portion 14 may be said to be substantially straight in the sense that it allows current to flow substantially along a straight line connecting the input area 11 and the beginning of the meandering portion of each conductive path. Each conductive path comprises an upstream 15 and a downstream 16 connection site, respectively located at the beginning and end of the meandering portion. The voltage drop over the meandering portion can be determined by electrically connecting the poles of a voltmeter or equivalent circuitry between the connection sites 15, 16, as will be discussed with reference to figure 4.

As exemplified by figure 3, the section of the conductive path joining the two connection sites 15, 16 is approximately 3.7 times as long as the distance between the connection sites 15, 16. In other embodiments, a corresponding section of the conductive path may be at least 2 times, preferably 5 times, preferably 10 times as long as the distance between the connection sites. This is advantageous since the connection leads of the voltmeter can be kept reasonably short.

Figure 4 is a top view of a conductive layer 10 belonging to a two-layer busbar according a further embodiment of the present invention. The conductive layer 10 has a machined pattern 13 which defines four parallel conductive paths. For illustration purposes, figure 4 shows a capacitor 401 having its two poles connected to the input area 11 of the shown conductive layer 10 and to an input area 21 of a second conductive layer (not shown) of the busbar. The two input areas 11, 21 may be suitable for connecting a capacitor 401 serving as a direct-current capacitor for intermediate storage of electric energy that may be supplied via conductors and/or for smoothing purposes. Figure 4 further shows four semiconductor devices 402, which are connected between a respective output area 12 of the shown conductive layer 10 and an output area 22 of the second conductive layer (not shown). Accordingly, between the poles of the capacitor 401, there are four closed electric circuits, including a first circuit composed of: the input area 11 in the first conductive layer 10 - the straight portion of the first conductive path - the meandering portion of the first conductive path - the first output area 12a of the first conductive layer 10 - the first semiconductor device 402a, the first output area 22a of the second conductive layer (not shown) - a conductive path of the second conductive layer (not shown) - the input area 21 of the second conductive layer (not shown).

Unlike the conductive layer shown in figure 3, the conductive layer 10 illustrated in figure 4 comprises a single dedicated connection site 15 for each conductive path, namely, the upstream connection site. The respective output areas 12 are used additionally as downstream conductive site, that is, for connecting one pole of the measurement equipment. In other words, the downstream conductive site coincides with the output area 12. Figure 4 further shows a first example current monitoring arrangement comprising resistors *Rᵢₙ*, *R_{f}* and an operational amplifier 403 configured to perform non-inverting amplification of the voltage drop between the first upstream connection site 15a and the first output area 12a. A theoretical gain factor may be equal to 1 + *R_{f}*/*Rᵢₙ*. The current monitoring arrangement further comprises a sensor 404 for reading the amplified output of the operational amplifier 403. Clearly, similar current monitoring arrangements may be provided at the second, third and fourth conductive paths on the first conductive layer 10.

The current monitoring arrangements may be used to monitor derived electric quantities as well. In particular, the value of a capacitor connected to the busbar 100, such as the capacitor 401, may be monitored on the basis of the measured current.

The inventors furthermore envisage a second example current monitoring arrangement, which may replace the first example current monitoring arrangement but otherwise be connected in the same manner, to the upstream connection site 15 and the output area 12. On a general functional level, the second example current monitoring arrangement is configured to separate low-frequency and high-frequency components of the measured voltage drop into separate branches of circuitry. This may be achieved by letting measurements on the low-frequency components primarily rely on the resistive properties of the conductive layer 10, whereas measurements on the high-frequency components may be based on inductive phenomena. The two signals picked up in this manner may undergo low-pass and high-pass filtering, respectively, and optional gain calibration before they are summed together, to form a complete frequency representation of the voltage drop signal. The second example current monitoring arrangement may be more sophisticated to implement but may provide greater accuracy and a more even output over the studied frequency range.

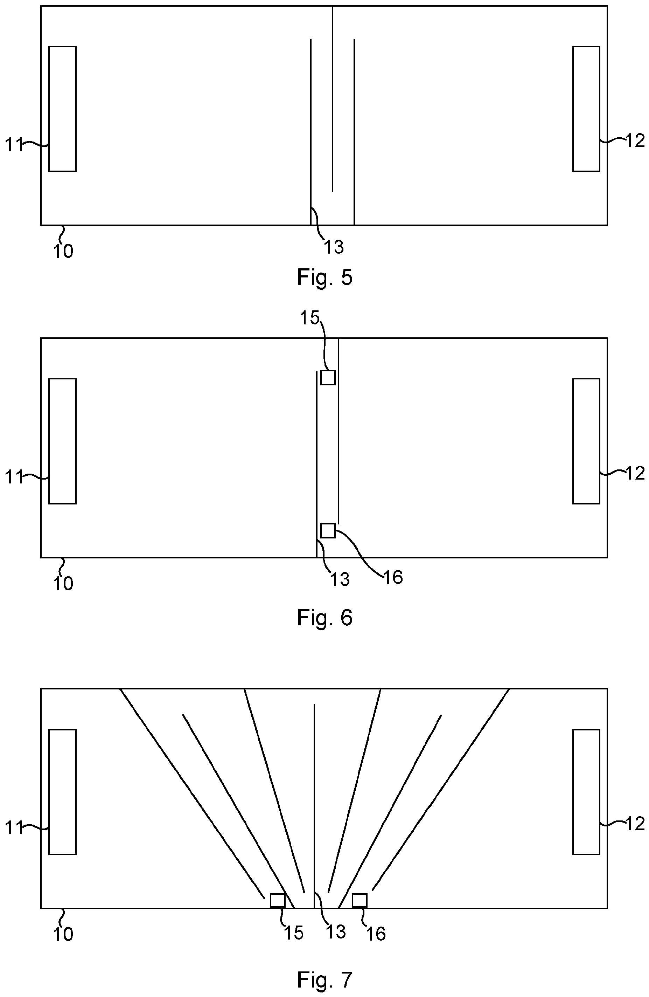

Figure 5 illustrates, in accordance with a further embodiment, a machined pattern 13 on a conductive layer 10 of a busbar for providing a meandering conductive path. The machined pattern 13, which comprises three vertical slots, defines a conductive path with two segments where the current is conveyed in a direction differing from an imaginary straight line between the input area 11 and output area 12.

In accordance with a still further embodiment, figure 6 shows a conductive layer 10 with a machined pattern 13 having a mere two vertical slots. The slots of the machined pattern 13 define a conductive path that is not only slightly longer than an imaginary straight line between the input area 11 and output area 12, but also significantly narrower in its central segment. Connection sites 15 and 16 are provided to allow connection of measurement circuitry for monitoring the voltage drop along the central segment.

Finally, figure 7 shows a machined pattern 13 on a conductive layer 10 of a busbar for providing a meandering conductive path that includes at least one retrograde segment. More precisely, the conductive path between the input area 11 and the output area 12 comprises a meandering portion which begins at the upstream connection site 15 and ends at the downstream connection site 16. Between these sites 15, 16, the conductive path comprises a first segment oriented in an approximate northwest direction in the plane of figure 7, i.e., one where the flowing current approaches the input area 11 again. The first segment is follows by a second segment, in which the current flows in an approximate south-southeast direction, and a third segment that is vertically oriented. The conductive pattern continues through on the right-hand half of the conductive pattern 13, where a vertical fourth segment is follows by a north-northeast fifth segment, a southeast sixth segment. In the sixth segment, again, current will be forced geometrically closer to the input area 11 and away from the output area 12, that is, away from the general direction of travel. For this reason, the first and sixth segments may be referred to as retrograde segments. Machined patterns which define one or more retrograde segments are advantageous since the connection sites 15, 16 can be placed with a small geometric separation even though they are joined by a long portion of the conductive path. This is space-saving and/or helps reduce the length of the connection lines towards the measurement circuitry.

In one example, a busbar according to any of the described embodiments has a nominal current of at least 10 A, such as at least 100 A. The resistance of the busbar may range from 20 to 20 000 µΩ, such as 250 to 20 000 µΩ, or preferably 50 to 500 µΩ. In cases where multiple parallel conductive paths are provided, the resistance values apply for one conductive path.

In another example, the busbar has a nominal current of at least 400 A and a resistance of 1 to 500 µΩ, preferably 10 to 100 µΩ, for one conductive path. Even for the highest resistance values, the losses due to current monitoring is of the order of tens of watts.

By way of quantitative comparison in an example case, the resistance and inductance of a conductive busbar layer without and with a machined pattern 13 of the type shown in figures 3 and 4 have been simulated by finite-element modeling using Ansys^{™} software. The simulation parameters and results are summarized in Table 1.

| Table 1: Simulation of busbar layers | | |
|---|---|---|
| | Without pattern | With pattern |
| Inter-layer distance (d) | 300 µm | 300 µm |
| Width of pattern | - | 1 mm |
| Total inductance | 0.3 nH | 2.1 nH |
| Total resistance | 3.7 µΩ | 22.5 µΩ |
| Resistance per parallel conductive path | - | 90 µΩ |
| Simulation frequency | 50 Hz | 50 Hz |

In the notation introduced above, the simulation provides *k_{R}* ≈ 24, *k_{L}* ≈ 7 per path. Accordingly, the provision of the machined pattern increases the resistance much more than it increases the inductance.

The aspects of the present disclosure have mainly been described above with reference to a few embodiments and examples thereof. However, as is readily appreciated by a person skilled in the art, other embodiments than the ones disclosed above are equally possible within the scope of the invention, as defined by the appended patent claims.

## Claims

1. Power electronics circuitry, comprising:
a busbar (100) comprising a first conductive layer (10) with an input area (11) and an output area (12),
wherein the conductive layer has a machined pattern (13) defining a meandering conductive path between the input area and the output area; and
wherein the power electronics circuitry further comprises: a current monitoring arrangement (403,404) adapted to sense a voltage drop over said meandering conductive path; the power electronics circuitry being **characterised by** a direct-current capacitor (401) connected at the input area of the busbar;
a semiconductor device (402) connected at the output area of the busbar.

2. The power electronics circuitry of claim 1, wherein the conductive path is at least 110%, preferably at least 125%, preferably at least 150%, preferably at least 2 or 5 or 10 times as long as the distance from the input area to the output area.

3. The power electronics circuitry of any of the preceding claims, wherein the provision of the machined pattern increases the resistance between the input area and the output area by a factor greater than or equal to a concomitant inductance increase.

4. The power electronics circuitry of any of the preceding claims, for which any of the following holds:
a) the busbar has a nominal current of at least 10 A and a resistance of 20 to 20 000 µΩ, preferably 50 to 500 µΩ, for one conductive path;
b) the busbar has a nominal current of at least 400 A and a resistance of 1 to 500 µΩ, preferably 10 to 100 µΩ, for one conductive path.

5. The power electronics circuitry of any of the preceding claims, wherein the conductive path includes parallel adjacent opposite sections.

6. The power electronics circuitry of any of the preceding claims, wherein a width of the machined pattern is at most 3 mm, preferably at most 2 mm, preferably at most 1 mm.

7. The power electronics circuitry of any of the preceding claims, wherein the conductive layer has plural output areas (12a, 12b, 12c, 12d) and the machined pattern defines a meandering conductive path from the input area to a respective one of the output areas.

8. The power electronics circuitry of claim 7, wherein the plural meandering conductive paths share a common portion (14) proximate to the input area.

9. The power electronics circuitry of claim 8, wherein the common portion is substantially straight.

10. The power electronics circuitry of any of the preceding claims, wherein the machined pattern is a chemically or photochemically machined pattern, preferably an etched pattern, a laser-cut pattern or a waterjet-cut pattern.

11. The power electronics circuitry of any of the preceding claims, wherein the machined pattern is cut through the first conductive layer.

12. The power electronics circuitry of any of the preceding claims, further comprising connection sites (15, 16) allowing to sense a voltage drop over the conductive path.

13. The power electronics circuitry of claim 12, wherein one of the connection sites coincides with the output area.

14. The power electronics circuitry of claim 12 or 13, wherein a section of the conductive path joining two connection sites (15, 16) is at least 2 times, preferably 5 times, preferably 10 times as long as the distance between the connection sites.

15. The power electronics circuitry of claim 14, wherein said section includes at least one retrograde segment.

16. The power electronics circuitry of any of the preceding claims, further comprising a parallel second conductive layer (20), which is separated from the first conductive layer and comprises a second input area (21) and second output area (22).

17. The power electronics circuitry of claim 16, wherein the first and second conductive layers are separated by a void and/or by an insulating layer.

## Patentansprüche

1. Leistungselektronikschaltungsanordnung, die Folgendes umfasst:
eine Sammelschiene (100), die eine erste leitfähige Schicht (10) mit einem Eingangsbereich (11) und einem Ausgangsbereich (12) umfasst,
wobei die leitfähige Schicht ein maschinell erzeugtes Muster (13) aufweist, das einen mäanderförmigen leitfähigen Pfad zwischen dem Eingangsbereich und dem Ausgangsbereich definiert; und
wobei die Leistungselektronikschaltungsanordnung ferner Folgendes umfasst: eine Stromüberwachungsanordnung (403, 404), die dazu ausgelegt ist, einen Spannungsabfall an dem mäanderförmigen leitfähigen Pfad zu erfassen; wobei die Leistungselektronikschaltungsanordnung durch Folgendes gekennzeichnet ist:
einen Gleichstromkondensator (401), der an dem Eingangsbereich der Sammelschiene verbunden ist;
eine Halbleitervorrichtung (402), die an dem Ausgangsbereich der Sammelschiene verbunden ist.

2. Leistungselektronikschaltungsanordnung nach Anspruch 1, wobei der leitfähige Pfad mindestens 110 %, vorzugsweise mindestens 125 %, vorzugsweise mindestens 150 %, vorzugsweise mindestens 2- oder 5- oder 10-mal so lang wie die Distanz von dem Eingangsbereich zu dem Ausgangsbereich ist.

3. Leistungselektronikschaltungsanordnung nach einem der vorhergehenden Ansprüche, wobei das Bereitstellen des maschinell erzeugten Musters den Widerstand zwischen dem Eingangsbereich und dem Ausgangsbereich um einen Faktor erhöht, der größer als oder gleich einer damit einhergehenden Zunahme der Induktivität ist.

4. Leistungselektronikschaltungsanordnung nach einem der vorhergehenden Ansprüche, für eines der Folgenden gilt:
a) die Sammelschiene weist einen Nennstrom von mindestens 10 A und einen Widerstand von 20 bis 20000 µΩ, vorzugsweise 50 bis 500 µΩ, für einen leitfähigen Pfad auf;
b) die Sammelschiene weist einen Nennstrom von mindestens 400 A und einen Widerstand von 1 bis 500 µΩ, vorzugsweise 10 bis 100 µΩ, für einen leitfähigen Pfad auf.

5. Leistungselektronikschaltungsanordnung nach einem der vorhergehenden Ansprüche, wobei der leitfähige Pfad parallele benachbarte gegenüberliegende Abschnitte beinhaltet.

6. Leistungselektronikschaltungsanordnung nach einem der vorhergehenden Ansprüche, wobei eine Breite des maschinell erzeugten Musters höchstens 3 mm, vorzugsweise höchstens 2 mm, vorzugsweise höchstens 1 mm beträgt.

7. Leistungselektronikschaltungsanordnung nach einem der vorhergehenden Ansprüche, wobei die leitfähige Schicht mehrere Ausgangsbereiche (12a, 12b, 12c, 12d) aufweist und das maschinell erzeugte Muster einen mäanderförmigen leitfähigen Pfad von dem Eingangsbereich zu einem jeweiligen der Ausgangsbereiche definiert.

8. Leistungselektronikschaltungsanordnung nach Anspruch 7, wobei sich die mehreren mäanderförmigen leitfähigen Pfade einen gemeinsamen Teil (14) in der Nähe des Eingangsbereichs teilen.

9. Leistungselektronikschaltungsanordnung nach Anspruch 8, wobei der gemeinsame Teil im Wesentlichen gerade ist.

10. Leistungselektronikschaltungsanordnung nach einem der vorhergehenden Ansprüche, wobei das maschinell erzeugte Muster ein chemisch oder photochemisch maschinell erzeugtes Muster ist, vorzugsweise ein geätztes Muster, ein lasergeschnittenes Muster oder ein wasserstrahlgeschnittenes Muster.

11. Leistungselektronikschaltungsanordnung nach einem der vorhergehenden Ansprüche, wobei das maschinell erzeugte Muster durch die erste leitfähige Schicht geschnitten ist.

12. Leistungselektronikschaltungsanordnung nach einem der vorhergehenden Ansprüche, die ferner Verbindungsstellen (15, 16) umfasst, die das Erfassen eines Spannungsabfalls an dem leitfähigen Pfad gestatten.

13. Leistungselektronikschaltungsanordnung nach Anspruch 12, wobei eine der Verbindungsstellen mit dem Ausgabebereich zusammenfällt.

14. Leistungselektronikschaltungsanordnung nach Anspruch 12 oder 13, wobei ein Abschnitt des leitfähigen Pfads, der zwei Verbindungsstellen (15, 16) verbindet, mindestens das 2-mal, vorzugsweise 5-mal, vorzugsweise 10-mal so lang wie die Länge des Abstands zwischen den Verbindungsstellen ist.

15. Leistungselektronikschaltungsanordnung nach Anspruch 14, wobei der Abschnitt mindestens ein umgekehrtes Segment beinhaltet.

16. Leistungselektronikschaltungsanordnung nach einem der vorhergehenden Ansprüche, die ferner eine parallele zweite leitfähige Schicht (20) umfasst, die von der ersten leitfähigen Schicht getrennt ist und einen zweiten Eingangsbereich (21) und einen zweiten Ausgangsbereich (22) umfasst.

17. Leistungselektronikschaltungsanordnung nach Anspruch 16, wobei die erste und die zweite leitfähige Schicht durch einen Hohlraum und/oder durch eine Isolierschicht getrennt sind.

## Revendications

1. Circuit électronique de puissance, comprenant :
une barre omnibus (100) comprenant une première couche conductrice (10) avec une zone d'entrée (11) et une zone de sortie (12),
la couche conductrice ayant un motif usiné (13) définissant un chemin conducteur sinueux entre la zone d'entrée et la zone de sortie ; et
le circuit électronique de puissance comprenant en outre : un agencement de surveillance du courant (403, 404) adapté pour détecter une chute de tension sur ledit chemin conducteur sinueux ; le circuit électronique de puissance étant **caractérisé par**
un condensateur à courant continu (401) connecté à la zone d'entrée de la barre omnibus ;
un dispositif semi-conducteur (402) connecté à la zone de sortie de la barre omnibus.

2. Circuit électronique de puissance selon la revendication 1, dans lequel le chemin conducteur est au moins 110 %, de préférence au moins 125 %, de préférence au moins 150 %, de préférence au moins 2 ou 5 ou 10 fois plus long que la distance entre la zone d'entrée et la zone de sortie.

3. Circuit électronique de puissance selon l'une quelconque des revendications précédentes, dans lequel la fourniture du motif usiné augmente la résistance entre la zone d'entrée et la zone de sortie d'un facteur supérieur ou égal à une augmentation concomitante de l'inductance.

4. Circuit électronique de puissance selon l'une quelconque des revendications précédentes, pour lequel l'un des éléments suivants est vrai :
a) la barre omnibus a un courant nominal d'au moins 10 A et une résistance de 20 à 20 000 µΩ, de préférence de 50 à 500 µΩ, pour un chemin conducteur ;
b) la barre omnibus a un courant nominal d'au moins 400 A et une résistance de 1 à 500 µΩ, de préférence de 10 à 100 µΩ, pour un chemin conducteur.

5. Circuit électronique de puissance selon l'une quelconque des revendications précédentes, dans lequel le chemin conducteur comprend des sections opposées adjacentes parallèles.

6. Circuit électronique de puissance selon l'une quelconque des revendications précédentes, dans lequel la largeur du motif usiné est d'au plus 3 mm, de préférence d'au plus 2 mm, de préférence d'au plus 1 mm.

7. Circuit électronique de puissance selon l'une quelconque des revendications précédentes, dans lequel la couche conductrice comporte plusieurs zones de sortie (12a, 12b, 12c, 12d) et le motif usiné définit un chemin conducteur sinueux allant de la zone d'entrée à l'une des zones de sortie respectives.

8. Circuit électronique de puissance selon la revendication 7, dans lequel les multiples chemins conducteurs sinueux partagent une partie commune (14) à proximité de la zone d'entrée.

9. Circuit électronique de puissance selon la revendication 8, dans lequel la partie commune est sensiblement droite.

10. Circuit électronique de puissance selon l'une quelconque des revendications précédentes, dans lequel le motif usiné est un motif usiné chimiquement ou photochimiquement, de préférence un motif gravé, un motif découpé au laser ou un motif découpé au jet d'eau.

11. Circuit électronique de puissance selon l'une quelconque des revendications précédentes, dans lequel le motif usiné est découpé à travers la première couche conductrice.

12. Circuit électronique de puissance selon l'une quelconque des revendications précédentes, comprenant en outre des sites de connexion (15, 16) permettant de détecter une chute de tension sur le chemin conducteur.

13. Circuit électronique de puissance selon la revendication 12, dans lequel l'un des sites de connexion coïncide avec la zone de sortie.

14. Circuit électronique de puissance selon la revendication 12 ou la revendication 13, dans lequel une section du chemin conducteur reliant deux sites de connexion (15, 16) est au moins 2 fois, de préférence 5 fois, de préférence 10 fois plus longue que la distance entre les sites de connexion.

15. Circuit électronique de puissance selon la revendication 14, dans lequel ladite section comprend au moins un segment rétrograde.

16. Circuit électronique de puissance selon l'une quelconque des revendications précédentes, comprenant en outre une deuxième couche conductrice parallèle (20), qui est séparée de la première couche conductrice et comprend une deuxième zone d'entrée (21) et une deuxième zone de sortie (22).

17. Circuit électronique de puissance selon la revendication 16, dans lequel les première et deuxième couches conductrices sont séparées par un vide et/ou par une couche isolante.
